# EUROPÄISCHE PATENTANMELDUNG

(11) **EP 0 855 789 A2**
(43) Veröffentlichungstag der Anmeldung: **29.07.1998**
(21) Anmeldenummer: 98101106.7
(22) Anmeldetag: 23.01.1998
(51) Int. Cl.: H02M 3/156

(54) **Zeitgeber in einer Schaltungsanordnung zur Wandlung einer Gleichspannung in eine andere Gleichspannung**

(30) Priorität: 25.01.1997 DE 19702654
(71) Anmelder: ROBERT BOSCH GMBH, 70442 Stuttgart (DE)
(72) Erfinder: Schmiederer, Claus, 77688 Rheinau-Freistett (DE); Reiss, Klaus, 76571 Gaggenau (DE)

(57) **Zusammenfassung**

Ein Zeitgeber in einer Schaltungsanordnung zur Wandlung einer Gleichspannung in eine andere Gleichspannung legt entweder die Ausschaltzeit oder die Einschaltzeit eines Schalttransistors (1) fest. Im Zeitgeber ist ein gemeinsamer Kondensator (8) sowohl für die Festlegung der Ausschalt- als auch der Einschaltzeit des Schalttransistors (1) vorgesehen. Die Aufladung des gemeinsamen Kondensators (8) erfolgt über einen ersten Widerstand (5) und die Entladung über einen zweiten Widerstand (6). Die beiden Zweige sind derart entkoppelt, daß die Entladung nicht durch den ersten Widerstand (5) im Ladezweig beeinflußt ist. Vorzugsweise wird eine Diode (4) zur Entkopplung verwendet, welche in Reihe mit dem ersten Widerstand (5) im Ladezweig liegt. Der Zeitgeber wird in vorteilhafter Weise in einem Steuergerät für die Leistungsversorgung von Hochdruck-Gasentladungslampen, insbesondere in Kraftfahrzeugen verwendet.

## Beschreibung

### Stand der Technik

Die Erfindung geht aus von einem Zeitgeber in einer Schaltungsanordnung zur Wandlung einer Gleichspannung in eine andere Gleichspannung, der im Oberbegriff des Anspruchs 1 definierten Gattung.

Bei einer aus der WO 95/14608 bekannten Schaltungsanordnung enthält der Spannungswandler eine Speicherdrossel und einen Leistungsschalter. Dessen Ein- und Ausschalten wird von dem in der Speicherdrossel fließenden Strom festgelegt. Dazu vergleicht ein Vergleicher den in der Speicherdrossel fließenden Strom mit einem vorgegebenen Schwellwert. Beim Durchschreiten des Schwellwertes wird der Leistungsschalter geschaltet. Ein vorhandener Zeitgeber hält nach dem Auftreten eines Spannungssprungs an der Speicherdrossel den Leistungsschalter für die vom Zeitgeber festgelegte Zeit in dem vorhandenen Schaltzustand.

Bei dem aus dieser bekannten Schaltungsanordnung bekannten Zeitgeber erfolgt das Aufladen eines Kondensators mit einer Zeitkonstanten, die aus dem Kondensator und dem Ladewiderstand gebildet ist. Das Entladen des Kondensators erfolgt sowohl über den eigentlichen Entladewiderstand als auch den Ladewiderstand. Der große Nachteil dieser Schaltung besteht darin, daß wegen der Entladung auch über den Ladewiderstand dieser nicht so klein dimensioniert werden kann, daß auch bei kleinster Einschaltzeit des Schalttransistors die Kondensatorspannung ihren gewünschten Endwert erreicht. Dies hat dann wiederum zur Folge, daß sich die Ausschaltzeit verringert, da nun die Einschaltschwelle des Komparators früher erreicht wird. Die Schaltfrequenz des Spannungswandlers wird somit erhöht. Mit steigenden Frequenzen erniedrigen sich die durch den Ferritkern des DC/DC-Wandlers übertragbaren Leistungen und die Schaltverluste des Schalttransistors erhöhen sich. Der Wirkungsgrad des Spannungswandlers verringert sich. Darüber hinaus wird genau in dem Betriebsbereich, in welchem der Spannungswandler die höchsten Leistungen an die Last abgeben soll, dies durch die stetige Frequenzerhöhung unterlaufen.

### Vorteile der Erfindung

Der erfindungsgemäße Zeitgeber in einer Schaltungsanordnung zur Wandlung einer Gleichspannung in eine andere Gleichspannung mit den kennzeichnenden Merkmalen des Anspruchs 1 hat demgegenüber den Vorteil, daß die Ladezeitkonstante so dimensioniert werden kann, daß die Kondensatorspannung immer einen genau definierten Wert, den Endwert erreicht. Der Spannungswandler kann dadurch immer in genau dem Frequenzbereich betrieben werden, in dem das Ferritmaterial des Übertragers eine möglichst hohe Übertragungsleistung zuläßt. Der Wirkungsgrad bei hohen Abgabeleistungen wird durch den Betrieb des Spannungswandlers in einem moderaten Frequenzbereich deutlich verbessert.

Wird die Erfindung beispielsweise in einem Steuergerät für die Versorgung von Hochdruck-Gasentladungslampen, insbesondere in Kraftfahrzeugen, eingesetzt, dann ist die Stromaufnahme des Steuergeräts aus dem Bordnetz erheblich verringert. Die Leistungshalbleiter, insbesondere der Schalttransistor und die Kommutierungsdiode des Spannungswandlers, werden weniger stark beansprucht, wodurch die Qualität und Zuverlässigkeit des Steuergeräts gesteigert ist.

Gemäß der grundlegenden Lösung vorliegender Erfindung ist in dem Zeitgeber ein gemeinsamer Kondensator sowohl für die Festlegung der Ausschalt- als auch der Einschaltzeit des Schalttransistors vorgesehen ist, die Aufladung des gemeinsamen Kondensators erfolgt über einen ersten Widerstand und die Entladung über einen zweiten Widerstand, und die beiden Zweige sind derart entkoppelt, daß die Entladung nicht durch den Widerstand im Ladezweig beeinflußt ist.

Durch die in den weiteren Ansprüchen niedergelegten Maßnahmen sind vorteilhafte Weiterbildungen und Verbesserungen des im Anspruch 1 angegebenen Zeitgebers möglich.

In besonders vorteilhafter Weiterbildung der Erfindung ist in Reihe mit dem ersten Widerstand im Ladezweig eine Diode zur Entkopplung der beiden Zweige vorgesehen, welche eine Entladung des gemeinsamen Kondensators über den ersten Widerstand im Ladezweig verhindert. Dadurch wird eine besonders einfache und sehr wirksame Entkopplung der beiden Zweige erreicht. Der Entladezweig ist nicht mehr vom Ladezweig beeinflußt.

Gemäß einer besonders vorteilhaften Ausgestaltung des erfindungsgemäßen Zeitgebers ist die Zeitkonstante für die Aufladung des gemeinsamen Kondensators so gewählt, daß bei der kleinsten Einschaltzeit des Schalttransistors die Spannung am gemeinsamen Kondensator einen genau definierten Endwert erreicht.

In besonders zweckmäßiger Weiterbildung dieser Ausgestaltung des erfindungsgemäßen Zeitgebers ist der im Ladezweig vorgesehene erste Widerstand niederohmig.

Entsprechend einer weiteren besonders vorteilhaften Ausgestaltung der Erfindung ist die maximale Ausschaltzeit des Schalttransistors durch die aus dem gemeinsamen Kondensator und dem zweiten Widerstand im Entladezweig gebildete Zeitkonstante bestimmt. Da der Kondensator immer auf einen definierten Endwert aufgeladen wird, ist damit sichergestellt, daß der Spannungswandler nicht in unerwünschten höheren Frequenzen weniger Leistung abgibt.

Gemäß einer anderen zweckmäßigen Ausgestaltung der Erfindung ist zur genauen Definierung der Lade- und Entladezeiten auch im Bezug auf unterschiedliche Temperaturen als gemeinsamer Kondensator ein temperaturstabiler Kondensator, insbesondere ein Keramikkondensator aus NP₀-Material, vorgesehen.

Der erfindungsgemäße Zeitgeber in der Schaltungsanordnung zur Wandlung einer Gleichspannung in eine andere Gleichspannung kann gemäß besonders zweckmäßiger Verwendung in einem Kraftfahrzeug eingesetzt werden. Dabei kann er beispielsweise in einer Steuerschaltung für Hochdruck-Gasentladungslampen, die zunehmend in Kraftfahrzeugen zur Bereitstellung höherer Beleuchtung bei geringerem Leistungsbedarf eingesetzt werden, in vorteilhafter Weise Verwendung finden. Dabei sichert der erfindungsgemäße Zeitgeber insbesondere bei Unterspannung der Batterie eine höhere Leistungsabgabe an die Lampe, als dies mit bisher bekannten Steuergeräten der Fall ist.

### Zeichnung

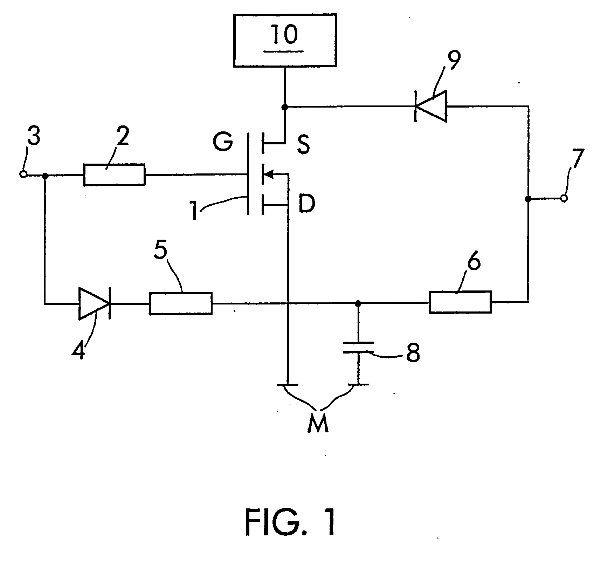

Die Erfindung ist anhand eines in der Zeichnung dargestellten Ausführungsbeispiels in der nachfolgenden Beschreibung näher erläutert. Die einzige Figur zeigt schematisch ein Schaltbild der erfindungsgemäßen Zeitgebers in Zusammenhang mit einem Schalttransistor der Schaltungsanordnung zur Wandlung einer Gleichspannung in eine andere Gleichspannung.

### Beschreibung des Ausführungsbeispiels

Der erfindungsgemäß gestaltete Zeitgeber in einer Schaltungsanordnung zur Wandlung einer Gleichspannung in eine andere Gleichspannung arbeitet mit einem Schalttransistor 1 zusammen, der als Bestandteil des allgemein mit 10 bezeichneten DC/DC-Wandlers angesehen werden kann. Als Schalttransistor wird dazu insbesondere ein MOSFET-Leistungstransitor 1 verwendet. Über eine Widerstand 2 wird das Gate des Schalttransistors 1 mit der Gatespannung am Anschluß 3 versorgt. Am Anschluß 3 ist weiterhin die Anode einer Diode 4, die als Entkopplungsdiode wirkt, in Reihe mit einem ersten Widerstand 5 und einem zweiten Widerstand 6 angeschlossen. Der andere Anschluß des zweiten Widerstands 6 bildet den Ausgang 7 des Zeitgebers. Dieser Ausgang 7 wird einem nicht dargestellten Komparator zugeführt. Am Verbindungspunkt der beiden Widerstände 5 und 6 ist ein für den Lade- und Entladezweig gemeinsamer Kondensator 8 angeschlossen, dessen anderer Anschluß an Masse M liegt. Der Komparator-Ausgang 7 des Zeitgebers ist über die Anoden-Kathoden-Strecke einer Diode 9 zum einen mit der Source des Schalttransistors 1 und zum anderen mit dem DC/DC-Spannungswandler 10, der nur als Block angedeutet ist, verbunden.

Der DC/DC-Wandler 10, der auch allgemein als Spannungswandler ansprechbar ist, wird somit mittels des Schalttransistors 1 geschaltet, d.h. mit Strom versorgt oder nicht.

Die Funktionsweise des erfindungsgemäß gestalteten Zeitgebers ist folgende:
In der Phase, in welcher der Schalttransistor 1 leitend ist, lädt sich der Kondensator 8 über den ersten Widerstand 5 auf die am Anschluß 3 anliegende Gatespannung, vermindert um den Spannungsabfall über die Anoden-Kathoden-Strecke der Diode 4, auf. Über die Diode 9 und den zweiten Widerstand 6 wird eine bestimmte Spannung am Ausgang 7 ausgekoppelt und einem nicht dargestellten Komparator zugeführt. Diese Spannung am Komparator-Ausgang 7 ist proportional zu dem Produkt des Widerstandes der Drain-Source-Strecke des Schalttransistors 1 und dem durch den Schalttransistor 1 fließenden Strom. Erreicht der nicht dargestellte Komparator die Abschaltschwelle, dann wird durch Wegnahme der Gatespannung am Anschluß 3 der Schalttransistor 1 ausgeschaltet, d.h. gesperrt. Der DC/DC-Wandler 10 wird nicht mehr mit Strom versorgt.

Bei Wegnahme der Gatespannung am Anschluß 3, insbesondere durch Anlegen an Masse, liegt nunmehr auch die Anode der Diode 4 an Masse und die Diode 4 sperrt somit. Der Schalttransistor 1 bleibt nun solange gesperrt, bis die Einschaltbedingung erfüllt ist. Diese Einschaltbedingung des Komparators ist beispielsweise dann erfüllt, wenn die im Übertrager des Spannungswandlers 10 eingespeicherte Energie vollständig in den Lastkreis abgegeben worden ist und dann die Spannung über die Drain-Source-Strecke des Schalttransistors 1 durch Null schwingt. Dies ist der Fall beim sogenannten Dreiecksbetrieb des Spannungswandlers. Die andere Einschaltbedingung ist dann erfüllt, wenn die Einschaltung durch den Entladevorgang des Kondensators 8 mit dem Widerstand 6 erzwungen wird. Dies ist der Fall beim sogenannten Trapezbetrieb des Spannungswandlers.

Die Diode 4 in Reihenschaltung mit dem ersten Widerstand 5 im aus diesem und aus dem Kondensator 8 bestehenden Ladezweig entkoppelt diesen vom aus Kondensator 8 und zweiten Widerstand bestehenden Entladezweig des Zeitgebers. Den beiden Zweigen ist der Kondensator 8 gemeinsam. Durch die erfindungsgemäße Entkopplung von Lade- und Entladezweig, kann der erste Widerstand 5 niederohmig gewählt werden, um eine schnelle und immer sichere Aufladung des Kondensators 8 auf den gewünschte Endwert der Spannung zu erreichen. Die Aufladezeitkonstante wird durch die Werte des ersten Widerstandes 5 und des Kondensators 8 bestimmt. Dies ist besonders bei der geringsten Einschaltzeit des Schalttransistors 1 von entscheidender Bedeutung. Die maximale Ausschaltzeit des Schalttransistors 1 bestimmt sich aus den Werten des zweiten Widerstandes 6 und des Kondensators 8.

Gemäß einer vorteilhaften Ausgestaltung kann für den Kondensator 8 ein temperatur-stabiler bzw. -unabhängiger Kondensator verwendet werden, wodurch die Auf- und Entladezeiten auch über die Temperatur sehr genau definiert sind. Ein solcher Kondensator kann ein Keramikkondensator aus NP₀-Material sein.

Der erfindungsgemäß gestaltete Zeitgeber wird in vorteilhafter Weise in einem DC/DC-Spannungswandler eingesetzt, insbesondere zur Verwendung in einem Steuergerät für Hochdruck-Gasentladungslampen in Kraftfahrzeugen. Dort stellt er sicher, daß auch bei sehr niedriger Batteriespannung noch ausreichend Leistung an die Lampen abgegeben wird. Dies wird durch Betrieb des Spannungswandler in einem auf den Übertrager optimierten Frequenzbereich bei begrenzter Ausschaltzeit des Schalttransistors erreicht.

## Patentansprüche

1. Zeitgeber in einer Schaltungsanordnung zur Wandlung einer Gleichspannung in eine andere Gleichspannung, der entweder die Ausschaltzeit oder die Einschaltzeit eines Schalttransistors (1) festlegt,
dadurch gekennzeichnet, daß
in dem Zeitgeber ein gemeinsamer Kondensator (8) sowohl für die Festlegung der Ausschalt- als auch der Einschaltzeit des Schalttransistors (1) vorgesehen ist,
die Aufladung des gemeinsamen Kondensators (8) über einen ersten Widerstand (5) und die Entladung über einen zweiten Widerstand (6) erfolgt,
und die beiden Zweige derart entkoppelt sind, daß die Entladung nicht durch den Widerstand (5) im Ladezweig beeinflußt ist.

2. Zeitgeber nach Anspruch 1, dadurch gekennzeichnet, daß in Reihe mit dem ersten Widerstand (5) im Ladezweig eine Diode (4) zur Entkopplung der beiden Zweige vorgesehen ist, welche eine Entladung des gemeinsamen Kondensators (8) über den ersten Widerstand (5) im Ladezweig verhindert.

3. Zeitgeber nach Anspruch 1 oder 2, dadurch gekennzeichnet, daß die Zeitkonstante für die Aufladung des gemeinsamen Kondensators (8) so gewählt ist, daß bei der kleinsten Einschaltzeit des Schalttransistors (1) die Spannung am gemeinsamen Kondensator (8) einen genau definierten Endwert erreicht.

4. Zeitgeber nach Anspruch 3, dadurch gekennzeichnet, daß der im Ladezweig vorgesehene erste Widerstand (5) niederohmig ist.

5. Zeitgeber nach einem der vorigen Ansprüche, dadurch gekennzeichnet, daß die maximale Ausschaltzeit des Schalttransistors (1) durch die aus dem gemeinsamen Kondensator (8) und dem zweiten Widerstand (6) im Entladezweig gebildete Zeitkonstante bestimmt ist.

6. Zeitgeber nach einem der vorigen Ansprüche, dadurch gekennzeichnet, daß als gemeinsamer Kondensator (8) ein temperaturstabiler Kondensator, insbesondere ein Keramikkondensator aus NP₀-Material, vorgesehen ist.

7. Zeitgeber nach einem der vorigen Ansprüche, dadurch gekennzeichnet, daß er in einem Kraftfahrzeug verwendet wird, insbesondere in einem Steuergerät für die Leistungsversorgung von Hochdruck-Gasentladungslampen.
